Europäisches Patentamt

**European Patent Office**

Office européen des brevets

(11) Publication number: **0 309 272**
**A2**

(12) **EUROPEAN PATENT APPLICATION**

(21) Application number: **88308859.3**

(22) Date of filing: **23.09.88**

(51) Int. Cl.⁴: **C 30 B 31/14**

(30) Priority: **25.09.87 US 100961**

(43) Date of publication of application:
**29.03.89 Bulletin 89/13**

(84) Designated Contracting States: **DE FR GB NL**

(71) Applicant: **SOUTHTECH, INC.**
**1713 E. Broadway Rd. Suite 296**
**Tempe Arizona 85282 (US)**

(72) Inventor: **Gardner, Steven J.**
**8637 San Alfredo Drive**
**Scottsdale Arizona 85258 (US)**

(74) Representative: **Funge, Harry et al**
**WILSON, GUNN & ELLIS 41-51 Royal Exchange Cross Street**
**Manchester M2 7BD (GB)**

(54) Apparatus and method for sample holders and wafer cages fabricated from silicon carbide for processing semiconductor materials.

(57) In order to avoid the problems associated with the use of wafer cages and sampel holders fabricated from quartz and currently used materials during the processing of semiconducting materials, the technique for providing wafer cages and, sample holders comprised entirely of silicon carbide is described. The wafer cage is first fabricated from graphite stock and the fabricated wafer cage is completely converted to silicon carbide material by means of a high temperature silicon monoxide source. The silicon carbide wafer cages permit direct exposure to the reactive environments necessary for fabrication of semiconductor materials and other materials processed in the presence of reactive environments. The process can include procedures for minimizing the presence of impurities in the silicon carbide wafer cages and sample holders.

EP 0 309 272 A2

Bundesdruckerei Berlin

Description

## APPARATUS AND METHOD FOR SAMPLE HOLDERS AND WAFER CAGES FABRICATED FROM SILICON CARBIDE FOR PROCESSING SEMICONDUCTOR MATERIALS

### RELATED APPLICATIONS

This application is related to the following U.S. Patent Applications.

APPARATUS AND METHOD FOR A SILICON CARBIDE CHEMICAL VAPOR DEPOSITION WAFER BOAT invented by Edwin W. Sabin; having Serial No. 07/100960 ; filed on 25.09.1988 and assigned to the assignee of the present U.S. Patent Application.

METHOD AND APPARATUS FOR A SILICON CARBIDE CHEMICAL VAPOR DEPOSITION WAFER BOAT invented by Edwin W. Sabin; having Serial No. 07/100955 ; filed on 25.09.1988 and assigned to the assignee of the present U.S. Patent Application.

### BACKGROUND OF THE INVENTION

#### 1. Field of the Invention

This invention relates generally to the processing of semiconductor wafers and samples from which semiconductor devices are fabricated and, more particularly, to wafer cages and sample holders for securing the semiconductor materials during the chemical deposition and processing procedures.

#### 2. Description of the Related Art

In the related art, several materials have been used to provide wafer cages and other sample holders which secure materials exposed to reactive environments during processing procedures. The wafer cages, sample holders and similar structures must, therefore, be able to withstand direct exposure to various reactive agents over a wide range of temperatures. These structures are typically comprised of mixtures or compounds including metals, quartz and polysilicon materials. These materials can be degraded on exposure to the reactive processing materials at elevated temperatures or can be degraded when exposed to cleaning agents that are required to remove the by-products of the desired reaction process. The degradation results in the presence of contaminants that can compromise the performance of the semiconductor devices fabricated from the processed semiconductor materials that are secured during processing by the wafer cages and sample holders.

Another problem that can arise in the related art is a result of the dependence of uniformity of the reaction being determined by the tolerances of the dimensions of the resulting wafer cages and sample holders. For example, when the cages are fabricated from quartz, close tolerances can usually be obtained only through the use of diamond impregnated cutting tools. The diamond impregnated cutting tools are expensive and the use of such tools on quartz can result in high internal stresses in the quartz material. To remove the internal stresses, fire polishing can be used. However, the fire polishing compromises the close tolerances resulting from use of the cutting tools. Quartz also has the property that devitrification can occur with aging and the devitrification process can be accelerated by certain reactive gases. Devitrification causes the quartz cage to be more susceptible to breakage and can introduce undesirable contaminants into the environment of the semiconductor material during processing thereof.

A desirable material for use as sample holder or wafer cage is silicon carbide. The silicon carbide structures have been fabricated using two techniques. In the first technique, particulate silicon carbide is combined with a binder and heated in a mold. The resulting structure provides a satisfactory structure for use in the processing of semiconductor materials. However, the technique is expensive and the complexity of the resulting structures, because of the requirement for the use of the molds, is severely limited. Simple structures, such as silicon carbide wafer holders and spatulas, fabricated in this manner are commercially available. In the second technique, a graphite structure is exposed to a source of silicon monoxide molecules at high temperatures and a surface region of silicon carbide is formed. This technique has been described in prior United States Patent entitled SILICON CARBIDE ENCASED GRAPHITE ARTICLES AND THEIR PRODUCTION; invention by L.M. Woerner, W.C. Kivela and G.J. Quaal; having Serial No. 3,634,116 and issued on January 11, 1972. The resulting structure has the advantage that graphite is relatively easy to fabricate, permitting complex structures to be produced. However, silicon carbide is relatively porous and graphite atoms can migrate from the interior of the structure and contaminate the semiconductor material being processed.

A need has existed for material and wafer cages and for material and sample holders that are relatively impervious to the reactive environment, can be fabricated more easily and the dimensions maintained to more precise tolerances that is possible by current techniques, are relatively free from contaminating particles, can be easily cleaned and can be operated at higher temperature in the absence of precautionary procedures than is possible with currently available structures.

It is an object of the present invention to provide an improved technique for the fabrication of semiconductor wafers.

It is a feature of the present invention to provide wafer cages and sample holders that are comprised entirely of silicon carbide.

It is another feature of the present invention to provide a wafer cage that is fabricated from graphite and the resulting graphite cage is completely converted to silicon carbide.

It is a more particular feature of the present invention to provide a wafer cage that is fabricated from graphite stock and generally completely converted to silicon carbide, the conversion to silicon carbide being performed with a silicon monoxide source operating at high temperature.

It is yet another feature of the present invention to provide an improved refractory material or wafer cage that can be subjected to repeated chemical cleaning processes without substantial degradation.

It is another feature of the present invention to provide a silicon carbide wafer cage or sample holder which is relatively free of impurities.

## SUMMARY OF THE INVENTION

The aforementioned and other features are accomplished, according to the present invention, by providing a sample holder or wafer cage that is completely comprised of silicon carbide. The material or wafer cage is initially fabricated from graphite materials. After fabrication, the graphite sample holder or wafer cage is exposed to a source of silicon monoxide molecules at high temperature. The exposure is continued until the graphite has been completely converted to silicon carbide. As a result of this exposure, the entire sample holder or wafer cage has a silicon carbide composition. The resulting silicon carbide sample holder or wafer cage minimizes many of the undesirable features of the cage materials in current use while permitting the sample holder of wafer cage to have a complex structure. When a wafer cage or sample holder is not completely converted from a graphite material to a silicon carbide material, the structure can be cooled and then reexposed to the source of silicon monoxide molecules in the high temperature environment for more complete conversion. The graphite material can be outgassed and subjected to high purity silicon monoxide molecules in a high purity chamber to minimize the presence of impurities in the resulting silicon carbide structure.

These and other features of the present invention will be understood upon reading of the following description along with the drawings.

## BRIEF DESCRIPTION OF THE DRAWINGS

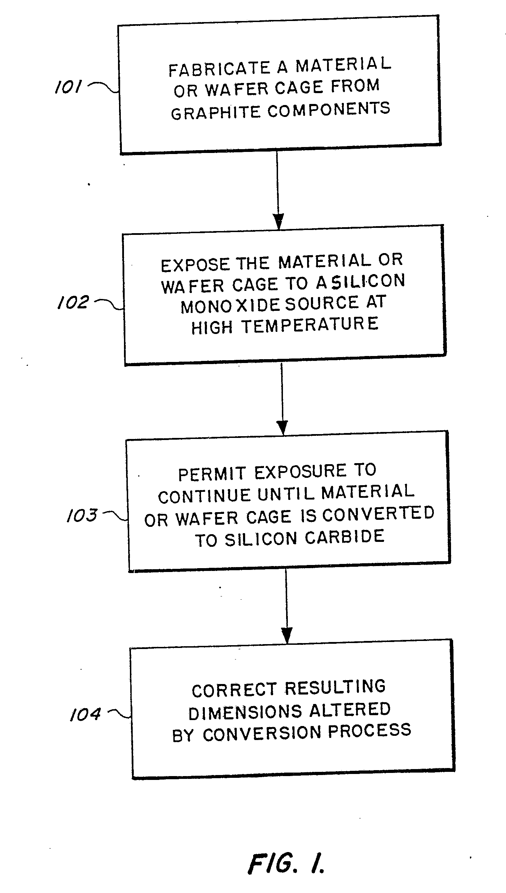

Figure 1 is a block diagram of the process of forming a sample holder or wafer cage, of substantially arbitrary structure, that is completely composed of silicon carbide.

## DESCRIPTION OF THE PREFERRED EMBODIMENT

## 1. Detailed Description of the Figure

Referring now to Fig. 1, the process for providing a sample holder or wafer cage, that is entirely composed of silicon carbide, is illustrated. In step 101, the material or wafer cage is fabricated from graphite materials. This step can include the fabrication of component pieces and the bonding (i.e., using graphite glue) of the component pieces to provide the desired cage configuration. Because of the relative ease of fabrication of graphite materials, the resulting geometry of the sample holder or wafer cage has relatively few limitations.

When a wafer cage or sample holder having a reduced level of impurities is desired, the graphite structure can be heated in a partial vacuum, resulting in an outgassing of the impurity components in the structure in step 102. In step 103, the fabricated cage is exposed to a source of silicon monoxide molecules in a high temperature environment. This exposure is continued in step 104 until the entire graphite structure is converted to silicon carbide. To minimize the level of impurities in the completed structure, the a high purity silicon monoxide source can be used in a impurity free environment (i.e., the process chamber can be comprised of high purity graphite). Where necessary, the dimensions of the resulting silicon carbide wafer cage or sample holder can be corrected to provide the desired cage dimensions in step 105. This step can also be accomplished for certain types of changes in the dimensions of the structure during the conversion procedure by appropriate adjustment of the dimensions of the graphite structure.

## 2. Operation of the Preferred Embodiment

In many anticipated applications of the present invention, the wafer cage or sample holder is for the processing of wafers and has the general shape of a cylindrical canister. The cylindrical canister typically has various configurations of openings in the surface of the canister to control the flow of the reactive agents with respect to the materials or samples secured within the cage. The structure is relatively complex and the properties of silicon carbide preclude the fabrication directly from silicon carbide stock. The use of a technique by which a slurry of silicon carbide particles and a bonding agent are combined in a mold limits the complexity of the possible structures that can be fabricated because of the difficulties of extricating the structure from the mold. The graphite members of the wafer cage or sample holder canister can frequently be fabricated from planar stock reducing the materials cost for the cage. The graphite components can then be bonded together with a substantially seamless bond. Finally, the conversion of the graphite material into silicon carbide material can be performed.

The resulting surface for the silicon carbide cage has a porous surface. The porous surface traps particles resulting from the chemical reaction, reducing the number of contaminants that can degrade the material (e.g., wafers) being processed.

The contaminants can be cleaned from the silicon carbide structure impacting the properties of the wafer cage or sample holder. The use of silicon carbide wafer cages and sample holders has the further advantage that processes can be performed at a higher temperature without compromise of the structural integrity of the cage. As contrasted with graphite structures in which only a surface portion has been converted to silicon carbide material, the graphite atoms are relatively immobile in the graphite structures completely converted to silicon carbide material and do not contribute to semiconductor material contamination.

Extending the length of the exposure to the silicon atoms in the high temperature environment can be ineffective for complete conversion of the graphite structure to a silicon carbide structure under certain conditions. It has been found that by permitting the partially converted graphite structure to be cooled (i.e., to room temperature in the preferred embodiment) and by reexposing the structure to the source of silicon monoxide molecules in a high temperature environment, more complete conversion of the graphite material to silicon carbide can be accomplished.

Because of the continually increasing requirement for purity in semiconductor and other materials, a need can arise to reduce the possible contaminants for the structures securing the material being processed. For impurity-free wafer cages and sample holders, the graphite structure can be provided with an outgassing step. Similarly, the source of high purity silicon monoxide molecules can be provided. For the conversion environment, a high purity graphite chamber or similar impurity free chamber can be provided. In this manner, a silicon carbide structure can be obtained that is relatively free of impurities which can be the source of contaminants during the processing of the semiconductor or other material secured by the wafer cage or sample holder.

The foregoing description is included to illustrate the operation of the preferred embodiment and is not meant to limit the scope of the invention. The scope of the invention is to be limited only by the following claims. From the foregoing description, many variations will be apparent to those skilled in the art that would yet be encompassed by the spirit and scope of the invention.

More particularly, it will be clear that the foregoing technique for providing silicon carbide structures is not limited to applications in the semiconductor industry.

## Claims

1. A wafer cage or sample holder structure for securing material members during exposure to reactive environments comprising: at least a first and second structure section, said first and said second structure sections being completely comprised of silicon carbide, said first and said second structure sections having a first configuration for placing said material members therein, said first and said second structure sections having a second configuration for securing said material members in a fixed relationship during said exposure to reactive environments.

2. The structure for securing material members of Claim 1 wherein said structure members have a plurality of apertures formed therein for permitting reactive gases to come in contact with said material members.

3. The structure for securing material members of Claim 1 wherein said first and said second structure sections are fabricated from graphite material and completely converted to silicon carbide.

4. The structure for securing material members of Claim 1 wherein said first and said second structure sections are converted to silicon carbide by exposure to a source of silicon monoxide molecules in a high temperature environment.

5. The structure for securing material members of Claim 4 wherein said silicon monoxide molecules have a low level of impurities.

6. The structure for securing material members of Claim 4 wherein said fabricated graphite material is heated and subjected to a partial vacuum prior to being converted to silicon carbide.

7. The method for fabricating wafer cage and sample holder structures for securing materials during exposure to reactive environments comprising the steps of: fabricating a wafer cage or sample holder structure from graphite; and converting said graphite wafer cage or sample holder structure substantially completely to a silicon carbide wafer cage or sample holder structure.

8. The method for fabricating wafer cage and sample holder structures of Claim 7 wherein said converting step includes exposing said graphite wafer cage or sample holder structure to a source of silicon atoms in a high temperature environment.

9. The method for fabricating wafer cage and sample holder structure of Claim 8 further comprising the steps of cooling said wafer cage or sample holder and reexposing said wafer cage or sample holder to said source of silicon monoxide molecules in a high temperature environment when conversion of graphite to silicon carbide is not substantially complete.

10. The method for fabricating wafer cage and sample holder structures of Claim 8 further comprising the step of correcting the dimensions of said wafer cages and said sample holders after conversion to silicon carbide.

11. The method for fabricating wafer cage and sample holder structures of Claim 7 further comprising the step of outgassing said wafer cage or sample holder structure prior to said converting step.

12. The method for fabricating wafer cage and sample holder structures of Claim 8 further comprising the step outgassing said wafer cage or sample holder structure prior to said converting step.

13. The method for fabricating wafer cage and sample holder structures of Claim 12 further comprising the step of providing a high purity source of silicon monoxide molecules.

14. the method of fabricating wafer cage and sample holder structures of Claim 13 further comprising the step of performing said converting step in a low impurity environment.

15. A silicon carbide structure comprising:
a graphite structure having substantially a configuration of said silicon carbide structure, wherein graphite of said graphite structure is completely converted to silicon carbide to form said silicon carbide structure.

16. The silicon carbide structure of Claim 15 wherein said graphite is converted to said silicon carbide by exposure to a source of silicon monoxide molecules in a high temperature environment.

17. The silicon carbide structure of Claim 16 wherein said graphite structure is cooled after exposure to said source of silicon monoxide molecules and thereafter re-exposed to said source of silicon monoxide molecules in said high temperature environment.

18. The silicon carbide structure of Claim 17 wherein said graphite structure is heated in a partial vacuum prior to exposure to said source of silicon monoxide molecules.

19. The structure for securing material members of Claim 4 wherein said first and said second structure sections are heated until a partial pressure prior to exposure to said silicon monoxide molecules

20. The structure for securing material members of Claim 4 wherein said first and said second structure sections are cooled after exposure to said silicon monoxide molecules, said first and said second structure sections thereafter reexposed to said silicon monoxide molecules.

101 — FABRICATE A MATERIAL
OR WAFER CAGE FROM
GRAPHITE COMPONENTS

102 — EXPOSE THE MATERIAL OR
WAFER CAGE TO A SILICON
MONOXIDE SOURCE AT
HIGH TEMPERATURE

103 — PERMIT EXPOSURE TO
CONTINUE UNTIL MATERIAL
OR WAFER CAGE IS CONVERTED
TO SILICON CARBIDE

104 — CORRECT RESULTING
DIMENSIONS ALTERED
BY CONVERSION PROCESS

*FIG. I.*